# EUROPEAN PATENT SPECIFICATION

(11) **EP 2 287 128 B1**
(45) Date of publication and mention of the grant of the patent: **23.05.2018**
(21) Application number: 10250263.0
(22) Date of filing: 16.02.2010
(51) Int. Cl.: C04B 35/495, H01L 41/187

(54) **Piezoelectric/electrostrictive ceramic composition**
Piezoelektrische/Elektrostriktive keramische Zusammensetzung
Composition céramique piézoélectrique/électrostrictive

(30) Priority: 14.07.2009 JP 2009165708
(43) Date of publication of application: 23.02.2011
(73) Proprietor: NGK Insulators, Ltd., Aichi Pref., 467-8530 (JP)
(72) Inventor: Kaigawa, Kazuyuki, Nagoya City Aichi-ken, 467-8530 (JP); Tanaka, Ritsu, Nagoya City Aichi-ken, 467-8530 (JP)
(74) Representative: Naylor, Matthew John

(56) References cited:
- EP-A1- 2 309 561
- EP-A2- 2 045 846

## Description

### BACKGROUND OF THE INVENTION

### Field of the Invention

The present invention relates to a sintered body of piezoelectric/electrostrictive ceramic composition.

### Description of the Background Art

A piezoelectric/electrostrictive actuator has an advantage that displacement can be controlled in a submicron order with accuracy. In particular, a piezoelectric/electrostrictive actuator, in which a sintered body of a piezoelectric/electrostrictive ceramic composition is used as a piezoelectric/electrostrictive body, has advantages such as high electromechanical conversion efficiency, large generating force, high response speed, high durability and less power consumption, in addition to the advantage that displacement can be controlled with accuracy. Thanks to these advantages, the piezoelectric/electrostrictive actuator is used in a head of an inkjet printer, an injector of a diesel engine and the like.

A lead-zirconate-titanate-based piezoelectric/electrostrictive ceramic composition has been conventionally used as a piezoelectric/electrostrictive ceramic composition for a piezoelectric/electrostrictive actuator. However, there are growing fears that elution of lead from a sintered body may affect global environment, which also leads to a study of an alkaline-niobate-based piezoelectric/electrostrictive ceramic composition.

Further, as described in Japanese Patent Application Laid-Open No. 2003-206179 and Japanese Patent Application Laid-Open No. 2004-244300, in order to improve piezoelectric/electrostrictive characteristics, an alkaline-niobate-based piezoelectric/electrostrictive ceramic composition containing Sb as a B-site element is studied as well.

Japanese Patent Application Laid-Open No. 2003-206179 describes that a tungsten-bronze-type oxide M(Nb_{1-w}Sb_{w})₂O₆ (where M is an alkali earth metal element) and an oxide of Mn are contained in a perovskite-type oxide (Li, Na, K)(Nb, Sb)₃.

Japanese Patent Application Laid-Open No. 2004-244300 describes that a compound of an element selected from the group consisting of alkali earth metal element, rare earth element, manganese and the like is contained in a perovskite-type oxide (Li, Na, K)(Nb, Ta, Sb)O₃. European Patent Applications EP 2 045 846 A2 and EP 2 309 561 A1 (post-published) provide (Li, Na, K)(Nb, Ta, Sb)O compositions with added Mn compounds. However, in a conventional alkaline-niobate-based piezoelectric/electrostrictive ceramic composition, electric field induced strain during application of high electric field, which is important for a piezoelectric/electrostrictive actuator, is not necessarily sufficient.

### SUMMARY OF THE INVENTION

According to the present invention, there is provided a piezoelectric/electrostrictive ceramic composition as set out in claim 1.

Accordingly, there is provided an alkaline-niobate-based piezoelectric/electrostrictive ceramic composition whose electric field induced strain during application of high electric field is excellent.

An object of the present invention is therefore to provide an alkaline-niobate-based piezoelectric/electrostrictive ceramic composition whose electric field induced strain during application of high electric field is excellent.

These and other objects, features, aspects and advantages of the present invention will become more apparent from the following detailed description of the present invention when taken in conjunction with the accompanying drawings.

### BRIEF DESCRIPTION OF THE DRAWINGS

FIG. 1 is a cross-sectional view of a piezoelectric/electrostrictive actuator;
FIG. 2 is another cross-sectional view of a piezoelectric/electrostrictive actuator;
FIG. 3 is still another cross-sectional view of a piezoelectric/electrostrictive actuator;
FIG. 4 is a perspective view of a piezoelectric/electrostrictive actuator;
FIG. 5 is a vertical cross-sectional view of the piezoelectric/electrostrictive actuator;
FIG. 6 is a lateral cross-sectional view of the piezoelectric/electrostrictive actuator; and
FIG. 7 is an exploded perspective view of a part of the piezoelectric/electrostrictive actuator.

### DESCRIPTION OF THE PREFERRED EMBODIMENTS

### (1 First Preferred Embodiment)

A first preferred embodiment relates to a piezoelectric/electrostrictive ceramic composition.

### (Use)

The piezoelectric/electrostrictive ceramic composition according to the first preferred embodiment is preferably used in an actuator as described in a second preferred embodiment to a fifth preferred embodiment. Note that use of the piezoelectric/electrostrictive ceramic composition according to the first preferred embodiment is not limited to an actuator. For example, the piezoelectric/electrostrictive ceramic composition according to the first preferred embodiment is used in a piezoelectric/electrostrictive element such as a sensor.

### (Composition)

The piezoelectric/electrostrictive ceramic composition according to the first preferred embodiment is a piezoelectric/electrostrictive ceramic composition, in which a compound of at least one kind of element (hereinafter, referred to as "selected element") selected from the group consisting of barium (Ba), strontium (Sr), calcium (Ca), lanthanum (La), cerium (Ce), neodymium (Nd), samarium (Sm), dysprosium (Dy), holmium (Ho) and ytterbium (Yb) and a compound of manganese (Mn) are contained in a perovskite-type oxide containing lithium (Li), sodium (Na) and potassium (K) as A-site elements and niobium (Nb) and antimony (Sb) as B-site elements, where a ratio of the total number of atoms of the A-site elements to the total number of atoms of the B-site elements is more than one and the number of atoms of Sb with respect to the total number of atoms of the B-site elements is 1 mol% or more and 10 mol% or less. A univalent element such as silver (Ag) may be further contained in the perovskite-type oxide as an A-site element, and a pentavalent element such as tantalum (Ta) and vanadium (V) may be further contained as a B-site element.

### (Perovskite-type oxide)

The first component of the piezoelectric/electrostrictive ceramic composition is a perovskite-type oxide whose composition is represented by a general formula {Li_{y}(Na₁₋ₓKₓ)_{1-y}}ₐ(Nb_{1-z-w}Ta_{z}Sb_{w})O₃. a, x, y, z and w satisfy 1<a≤1.05, 0.30≤x≤0.70. 0.02≤y≤0.10, 0≤z≤0.5, and 0.01≤w≤0.1, respectively.

An A/B ratio is set to 1<a for promoting grain growth to densify a sintered body. In addition, when the A/B ratio is 1<a, firing temperature for sufficiently densifying a sintered body is 1,100°C or lower, which prevents fluctuations in composition of the sintered body. It is conceivable that the generation of the secondary phase having a low-melting point is conducive to a decrease in firing temperature in the course of firing due to a surplus alkaline component. In addition, when the A/B ratio is 1<a, electric field induced strain during application of high electric filed increases by further performing aging on the sintered body after poling.

Conversely, the firing temperature for sufficiently densifying a sintered body becomes higher than 1,100°C when the A/B ratio is a≤1. If the firing temperature is raised, evaporation of an alkaline component is likely to occur, whereby the composition of the sintered body is likely to fluctuate.

The A/B ratio is set to a≤1.05 for decreasing dielectric loss to increase electric field induced strain during application of high electric field. An increase in dielectric loss causes a serious problem in a piezoelectric/electrostrictive ceramic composition for an actuator to which high electric field is applied.

An Sb substitution amount is set to 0.01≤w≤0.1 for bringing tetragonal-to-orthorhombic phase transition temperature (hereinafter, referred to as "phase transition temperature") T_{0T} close to room temperature to increase electric field induced strain during application of high electric field. The phase transition temperature T_{0T} is desirably 50°C or lower, and more desirably 10°C or lower.

An amount of K, an amount of Li and an amount of Ta are set to 0.30≤x≤0.70, 0.02≤y≤0.10 and 0≤z≤0.5, respectively, for obtaining a piezoelectric/electrostrictive ceramic composition suitable for an actuator.

If the amount of K falls below this range, electric field induced strain during application of high electric field decreases rapidly. On the other hand, if the amount of K exceeds this range, firing temperature for sufficiently densifying a sintered body becomes higher. If the amount of Li falls below this range, firing temperature for sufficiently densifying a sintered body becomes higher. On the other hand, if the amount of Li exceeds this range, a larger number of secondary phases are included in the sintered body, and accordingly an insulating property of the sintered body decreases. If the amount of Ta exceeds this range, firing temperature for sufficiently densifying a sintered body becomes higher.

### (Compound of selected element)

The second component of the piezoelectric/electrostrictive ceramic composition is a compound of at least one kind of element selected from the group consisting of Ba, Sr, Ca, La, Ce, Nd, Sm, Dy, Ho and Yb.

The compound of selected element is contained such that a content thereof in terms of atom of selected element with respect to 100 parts by mol of perovskite-type oxide is 0.01 parts by mol or more and 0.5 parts by mol or less. This is because electric field induced strain during application of high electric field tends to be small if the content of the compound of selected element falls below this range. On the other hand, if the content of the compound of selected element exceeds this range, a crystal phase changes from tetragonal to orthorhombic, and thus electric field induced strain during application of high electric field tends to be small.

The compound of selected element desirably becomes an oxide to be a solid solution with a perovskite-type oxide. That is, the selected element is desirably taken in a crystal lattice of a perovskite-type oxide which is a parent phase to be present inside the sintered body as an element constituting the parent phase. However, a small amount of the secondary phase containing the selected element may be present inside the sintered body.

### (Mn Compound)

The third component of the piezoelectric/electrostrictive ceramic composition is a Mn compound.

The Mn compound is contained such that a content thereof in terms of Mn atom with respect to 100 parts by mol of perovskite-type oxide is 3 parts by mol or less. This is because dielectric loss increases if the content of the Mn compound exceeds this range, whereby electric field induced strain during application of high electric field tends to be small.

There is no problem when the content of the Mn compound is extremely small. For example, even in a case where only 0.001 parts by mol of Mn compound is contained in 100 parts by mol of perovskite-type oxide in terms of Mn atom, poling of a sintered body is facilitated, with the result that electric field induced strain during application of high electric field increases owing to synergistic effect with substitution of Sb.

The Mn compound is desirably a compound of Mn whose valence is mainly divalent. For example, manganese oxide (MnO) or another compound of a solid solution formed by Mn is desirable, and in particular, a compound of a solid solution formed by Mn with tri-lithium niobate (Li₃NbO₄) is desirable. "Valence being mainly divalent" refers to that a compound of Mn whose valence is other than divalent may be contained and that a compound contained the most should be a compound of divalent Mn. The valence of Mn is checked by, for example, the X-ray absorption near-edge structure (XANES). In addition, Mn is present inside a sintered body as an element constituting the secondary phase of a Mn compound, without being taken in a crystal lattice of a perovskite-type oxide which is a parent phase. Accordingly, hardening by containing a Mn compound it prevented, which increases electric field induced strain.

### (Phase transition temperature)

Generally speaking, in an alkaline-niobate-based perovskite-type oxide and a modified product thereof, phase transition is sequentially caused in the order of cubic, tetragonal, and orthorhombic from high temperature toward low temperature, but in the piezoelectric/electrostrictive ceramic composition according to the first preferred embodiment, a composition is desirably selected so that the phase transition temperature T_{OT} is approximately room temperature. This is because electric field induced strain during application of high electric field increases if the phase transition temperature T_{OT} is approximately room temperature.

### (Crystal system and lattice strain)

In the piezoelectric/electrostrictive ceramic composition according to the first preferred embodiment, a composition is desirably selected such that a crystal phase is tetragonal and lattice strain thereof is small to some extent.

Specifically, in an X-ray diffraction pattern in which a Cu-Kα line is used in an X-ray source, the composition is desirably selected such that a ratio of an interval of (002)plane to an interval of (200)plane, that is, a ratio c/a of a lattice constant c in c-axis direction to a lattice constant a in a-axis direction is 1.003 or more and 1.025 or less. This is because domains rotate easily if the ratio c/a falls within this range, which improves electric field induced strain during application of high electric field.

### (Production of ceramics powders)

In producing ceramics powders of the piezoelectric/electrostrictive ceramic composition according to the first preferred embodiment, a dispersing medium is added to powders of raw materials of constituent elements (Li, Na, K, Nb, Ta, Sb and the like) of a perovskite-type oxide, and the powders of the raw materials to which the dispersing medium has been added are mixed with a ball mill or the like. As raw materials of constituent elements of a perovskite-type oxide, an oxide or a compound of carbonate, tartrate or the like which becomes an oxide in the course of calcination is used. As a dispersing medium, an organic solvent such as ethanol, toluene and acetone is used.

The dispersing medium is removed from the obtained mixed slurry through vaporization drying, filtering or the like, whereby a dried mixed material is obtained.

Calcination is performed on the dried mixed material at 600 to 1,300°C, whereby the powders of the perovskite-type oxide are synthesized. In order to obtain powders of a perovskite-type oxide having a desired particle diameter, grinding may be performed with a ball mill or the like after the calcination. Alternatively, powders of a perovskite-type oxide may be synthesized by an alkoxide method or coprecipatation method not by a solid-phase reaction method. Still alternatively, solid solutions of B-site elements (for example, composite oxide of a plurality of B-site elements) may be synthesized in advance and then be mixed with an A-site element for calcination, thereby synthesizing powders of a perovskite-type oxide.

An average particle diameter of powders of a perovskite-type oxide is desirably 0.07 to 10 µm, and more desirably 0.1 to 3 µm. Further, in order to adjust a particle diameter of powders of a perovskite-type oxide, heat treatment may be performed on powders of a perovskite-type oxide at 400 to 850°C. Powders of a perovskite-type oxide which has a uniform particle diameter are obtained through this heat treatment because more minute particles are likely to be integrated with other particle, with the result that a sintered body having a uniform particle diameter is obtained.

The powders of the raw materials for a compound of the selected element and a Mn compound are added to the powders of the perovskite-type oxide. Addition of powders of raw materials for the compound of the selected element and the Mn compound is performed by, for example, adding a dispersing medium to powders of a perovskite-type oxide and powders of raw materials for a compound of the selected element and a Mn compound and mixing those powders to which the dispersing medium has been added with a ball mill or the like.

As raw materials for the compound of the selected element and the Mn compound, an oxide or a compound of carbonate, tartrate or the like which becomes an oxide in the course of firing is used. As a raw material of Mn, manganese dioxide (MnO₂) in which a valence of Mn is quadrivalent is also used. Quadrivalent Mn which constitutes MnO₂ is reduced during firing to become divalent Mn, which contributes to an improvement in electric field induced strain during application of high electric field.

### (Production of sintered body)

In producing a sintered body of the piezoelectric/electrostrictive ceramic composition according to the first preferred embodiment, first, ceramics powders are formed by pressing, tape casting, casting or the like.

A formed body of ceramics powders is subjected to firing at 800 to 1,100°C. An electrode film is formed on a surface of the sintered body by screen printing, resistance heating evaporation, sputtering or the like. The formed body of ceramics powders and the electrode film may be integrally subjected to firing. An electrode film may be formed inside the sintered body. The sintered body may be processed by polishing or cutting.

Desirably, poling and aging are successively performed on the sintered body on which the electrode film is formed. Aging is omitted in some cases. Alternatively, in a case where an electric field exceeding a coercive electric field is applied during use, or in a case where an electrostrictive effect is entirely used, poling is also omitted in some cases.

In performing poling, the sintered body on which the electrode film is formed is immersed in insulating oil such as a silicon oil, whereby the electrode film is applied with voltage. On this occasion, high-temperature poling is desirably performed so as to heat the sintered body to 50 to 150°C. When high-temperature poling is performed, the sintered body is applied with electric field of 2 to 10 kV/mm.

In performing aging, the sintered body is heated to 100 to 300°C in the atmosphere in a state in which the electrode film is open.

### (2 Second Preferred Embodiment)

The second preferred embodiment relates to a single-layer piezoelectric/electrostrictive actuator 1 using the piezoelectric/electrostrictive ceramic composition according to the first preferred embodiment.

### (Outline of piezoelectric/electrostrictive actuator 1)

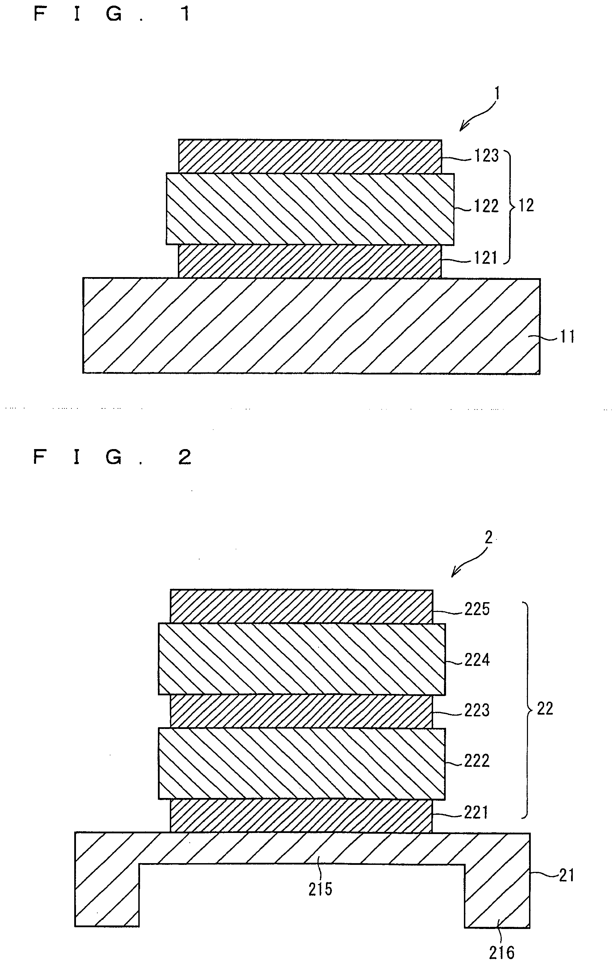

FIG. 1 is a schematic view of the piezoelectric/electrostrictive actuator 1 according to the second preferred embodiment. FIG. 1 is a cross-sectional view of the piezoelectric/electrostrictive actuator 1.

As shown in FIG. 1, the piezoelectric/electrostrictive actuator 1 has a structure in which an electrode film 121, a piezoelectric/electrostrictive film 122 and an electrode film 123 are laminated in this order on an upper surface of a substrate 11. The electrode films 121 and 123 on both principal surfaces of the piezoelectric/electrostrictive film 122 are opposed to each other with the piezoelectric/electrostrictive film 122 being sandwiched therebetween. A laminate 12 in which the electrode film 121, the piezoelectric/electrostrictive film 122 and the electrode film 123 are laminated is united to the substrate 11.

"Uniting" refers to bonding the laminate 12 to the substrate 11 by solid-phase reaction on an interface between the substrate 11 and the laminate 12 without using an organic adhesive or inorganic adhesive. Note that a laminate may be bonded to a substrate by solid-phase reaction on an interface between the substrate and a piezoelectric/electrostrictive film which is the lowermost layer of the laminate.

In the piezoelectric/electrostrictive actuator 1, upon application of a voltage to the electrode films 121 and 123, the piezoelectric/electrostrictive film 122 expands and contracts in a direction perpendicular to an electric field in response to the applied voltage, and as a result, bending displacement is caused.

### (Piezoelectric/electrostrictive film 122)

The piezoelectric/electrostrictive film 122 is a sintered body of the piezoelectric/electrostrictive ceramic composition according to the first preferred embodiment.

A film thickness of the piezoelectric/electrostrictive film 122 is desirably 0.5 to 50 µm, more desirably 0.8 to 40 µm, and particularly desirably 1 to 30 µm. This is because the piezoelectric/electrostrictive film 122 tends to be insufficiently densified if the film thickness thereof falls below this range. On the other hand, shrinkage stress during sintering increases if the film thickness of the piezoelectric/electrostrictive film 122 exceeds this range, and a plate thickness of the substrate 11 needs to be increased, which makes it difficult to miniaturize the piezoelectric/electrostrictive actuator 1.

### (Electrode films 121, 123)

A material for the electrode films 121 and 123 is metal such as platinum, palladium, rhodium, gold or silver, or an alloy thereof. Among those, platinum or an alloy mainly composed of platinum is favorable from the viewpoint of high heat resistance during firing. Alternatively, an alloy such as a silver-palladium alloy is favorably used depending on firing temperature.

Film thicknesses of the electrode films 121 and 123 are desirably 15 µm or less, and more desirably 5 µm or less. This is because the electrode films 121 and 123 function as buffer layers if the film thicknesses of the electrode films 121 and 123 exceed this range, and thus bending displacement tends to be small. Further, the film thicknesses of the electrode films 121 and 123 are desirably 0.05 µm or more in order that the electrode films 121 and 123 appropriately perform their function.

The electrode films 121 and 123 are desirably formed so as to cover a region which is substantially conducive to bending displacement of the piezoelectric/electrostrictive film 122. For example, the electrode films 121 and 123 are desirably formed so as to include a center portion of the piezoelectric/electrostrictive film 122 and cover a region of 80% or more of both principal surfaces of the piezoelectric/electrostrictive film 122.

### (Substrate 11)

Although a material for the substrate 11 is ceramic, a type thereof is not limited. However, from the viewpoints of heat resistance, chemical stability and insulating property, it is desirably a ceramic containing at least one kind selected from the group consisting of stabilized zirconium oxide, aluminum oxide, magnesium oxide, mullite, aluminum nitride, silicon nitride and glass. Among those, from the viewpoints of mechanical strength and tenacity, stabilized zirconium oxide is more desirable. The "stabilized zirconium oxide" refers to zirconium oxide in which crystal phase transition is suppressed by addition of a stabilizer, and includes partially-stabilized zirconium oxide in addition to stabilized zirconium oxide.

Examples of the stabilized zirconium oxide include, for example, zirconium oxide containing, as a stabilizer, 1 to 30mol% of calcium oxide, magnesium oxide, yttrium oxide, ytterbium oxide, cerium oxide or an oxide of rare earth metal. Among those, from the viewpoint of particularly high mechanical strength, zirconium oxide in which yttrium oxide is contained as a stabilizer. A content of yttrium oxide is desirably 1.5 to 6mol%, and more desirably 2 to 4mol%. Further, in addition to yttrium oxide, 0.1 to 5mol% of aluminum oxide may be desirably contained. A crystal phase of the stabilized zirconium oxide may be a mixed crystal of a cubic crystal and a monoclinic crystal, a mixed crystal of a tetragonal crystal and a monoclinic crystal, a mixed crystal of a cubic crystal, a tetragonal crystal and a monoclinic crystal, or the like. The main crystal phase is desirably a mixed crystal of a tetragonal crystal and a cubic crystal or a tetragonal crystal from the viewpoints of mechanical strength, tenacity and durability.

The plate thickness of the substrate 11 is uniform. The plate thickness of the substrate 11 is desirably 1 to 1,000 µm, more desirably 1.5 to 500 µm, and particularly desirably 2 to 200 µm. This is because the mechanical strength of the piezoelectric/electrostrictive actuator 1 tends to decrease if the plate thickness of the substrate 11 falls below this range. On the other hand, rigidity of the substrate 11 increases if the plate thickness of the substrate 11 exceeds this range, whereby bending displacement due to expansion and contraction of the piezoelectric/electrostrictive film 122 when voltage is applied tends to be small.

A shape of a surface (shape of a surface to which the laminate is fixed) of the substrate 11 is not particularly limited, and may be triangular, quadrangular (rectangular or square), elliptic or circular, where corners may be rounded in the triangular shape and quadrangular shape. The shape may be a composite shape obtained by combining those basic shapes.

### (Production of piezoelectric/electrostrictive actuator 1)

In manufacturing the piezoelectric/electrostrictive actuator 1, the electrode film 121 is formed on the substrate 11. The electrode film 121 is formed using ion beam, sputtering, vacuum deposition, physical vapor deposition (PVD), ion plating, chemical vapor deposition (CVD), plating, aerosol deposition, screen printing, spraying, dipping or other method. Among those, sputtering or screen printing is desirable from the viewpoint of bonding property between the substrate 11 and the piezoelectric/electrostrictive film 122. The formed electrode film 122 is united to the substrate 11 and the piezoelectric/electrostrictive film 122 through heat treatment. A temperature for heat treatment differs in accordance with a material for the electrode film 121 and a forming method therefor, and is approximately 500 to 1,400°C.

Subsequently, the piezoelectric/electrostrictive film 122 is formed on the electrode film 121. The piezoelectric/electrostrictive film 122 is formed using ion beam, sputtering, vacuum deposition, physical vapor deposition (PVD), ion plating, chemical vapor deposition (CVD), plating, sol-gel method, earosol deposition, screen printing, spraying, dipping or other method. Among those, considering that high accuracy is obtained in a planar shape and a film thickness and that piezoelectric/electrostrictive films can be successively formed, screen printing is desirable.

Successively, the electrode film 123 is formed on the piezoelectric/electrostrictive film 122. The electrode film 123 is formed in the same manner as the electrode film 121.

After the formation of the electrode film 123, the substrate 11 on which the laminate 12 is formed is integrally subjected to firing. Through this firing, sintering of the piezoelectric/electrostrictive film 122 proceeds and the electrode films 121 and 123 are subjected to heat treatment as well. The firing temperature of the piezoelectric/electrostrictive film 122 is desirably 800 to 1,250°C, and more desirably 900 to 1,200°C. This is because the piezoelectric/electrostrictive film 122 is insufficiently densified if the firing temperature of the piezoelectric/electrostrictive film 122 falls below this range, whereby uniting of the electrode film 121 to the substrate 11 or uniting of the electrode films 121 and 123 to the piezoelectric/electrostrictive film 122 tend to be insufficient. On the other hand, if the firing temperature of the piezoelectric/electrostrictive film 122 exceeds this range, piezoelectric/electrostrictive characteristics of the piezoelectric/electrostrictive film 122 tend to decrease. The period of time for holding the highest temperature during firing is desirably 1 minute to 10 hours, and more desirably 5 minutes to 4 hours. This is because if the period of time falls below this range, the piezoelectric/electrostrictive film 122 is insufficiently densified, while if the period of time exceeds this range, piezoelectric/electrostrictive characteristics of the piezoelectric/electrostrictive film 122 tend to decrease.

Note that heat treatment of the electrode films 121 and 123 is preferably performed together with firing from the viewpoint of productivity, which does not prevent the heat treatment from being performed every time the electrode film 121 or 123 is formed. However, in the case where firing of the piezoelectric/electrostrictive film 122 is performed prior to the heat treatment of the electrode film 123, the electrode film 123 is subjected to heat treatment at temperature lower than the firing temperature of the piezoelectric/electrostrictive film 122.

After the firing, poling and aging are performed on the piezoelectric/electrostrictive actuator.

The piezoelectric/electrostrictive actuator 1 is also manufactured by a green sheet laminating method which is commonly used in manufacturing laminated-layer ceramic electronic parts. In the green sheet laminating method, a binder, a plasticizer, a dispersing agent and a dispersing medium are added to ceramics powders, and ceramics powders, a binder, a plasticizer and a dispersing medium are mixed with a ball mill or the like. The obtained slurry is formed into a sheet shape by doctor blading or the like, whereby a formed body is obtained.

Subsequently, a film of electrode paste is printed on both principal surfaces of the formed body by screen printing or the like. The electrode paste used in this case is obtained by adding a solvent, vehicle, glass frit and the like to of the above-mentioned powders metal or alloy.

Subsequently, the formed body in which the film of electrode paste is printed on both principal surfaces thereof and the substrate are press-bonded to each other.

Thereafter, the substrate on which the laminate is formed is integrally subjected to firing and, after the firing, poling and aging are performed under appropriate conditions.

### (3 Third Preferred Embodiment)

The third preferred embodiment relates to a multi-layer piezoelectric/electrostrictive actuator 2 using the piezoelectric/electrostrictive ceramic composition according to the first preferred embodiment.

FIG. 2 is a schematic view of the piezoelectric/electrostrictive actuator 2 according to the third preferred embodiment. FIG. 2 is a cross-sectional view of the piezoelectric/electrostrictive actuator 2.

As shown in FIG. 2, the piezoelectric/electrostrictive actuator 2 has a structure in which an electrode film 221, a piezoelectric/electrostrictive film 222, an electrode film 223, a piezoelectric/electrostrictive film 224 and an electrode film 225 are laminated in this order on an upper surface of a substrate 21. The electrode films 221 and 223 on both principal surfaces of the piezoelectric/electrostrictive film 222 are opposed to each other with the piezoelectric/electrostrictive film 222 being sandwiched therebetween, and the electrode films 223 and 225 on both principal surfaces of the piezoelectric/electrostrictive film 224 are opposed to each other with the piezoelectric/electrostrictive film 224 being sandwiched therebetween. A laminate 22 in which the electrode film 221, the piezoelectric/electrostrictive film 222, the electrode film 223, the piezoelectric/electrostrictive film 224 and the electrode film 225 are laminated is united to the substrate 21. Note that though FIG. 2 shows the case of two layers of piezoelectric/electrostrictive films, three or more layers of piezoelectric/electrostrictive films may be provided.

The substrate 21 of the piezoelectric/electrostrictive film 2 has a small plate thickness at a center portion 215 to which the laminate 22 is bonded than at an edge 216. Accordingly, it is possible to increase bending displacement while keeping a mechanical strength of the substrate 21. The substrate 21 may be used in the piezoelectric/electrostrictive actuator 1 according to the second preferred embodiment.

The piezoelectric/electrostrictive actuator 2 is also manufactured in the same manner as the single-layer piezoelectric/electrostrictive actuator 1 except that the number of piezoelectric/electrostrictive films and electrode films to be formed increase.

### (4 Fourth Preferred Embodiment)

The fourth preferred embodiment relates to a multi-layer piezoelectric/electrostrictive actuator 3 using the piezoelectric/electrostrictive ceramic composition according to the first preferred embodiment.

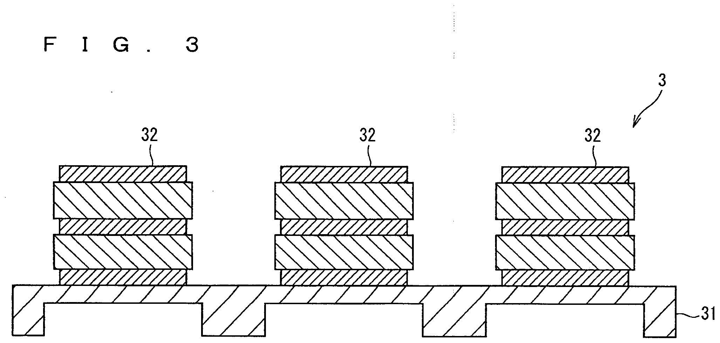

FIG. 3 is a schematic view of the piezoelectric/electrostrictive actuator 3 according to the fourth preferred embodiment. FIG. 3 is a cross-sectional view of the piezoelectric/electrostrictive actuator 3.

As shown in FIG. 3, the piezoelectric/electrostrictive actuator 3 includes a substrate 31 in which a unit structure having a similar structure to that of the substrate 21 according to the third preferred embodiment is repeated. A laminate 32 having a similar structure to that of the laminate 22 according to the third preferred embodiment is united to each unit structure of the substrate 31.

The piezoelectric/electrostrictive actuator 3 is also manufactured in the same manner as the single-layer piezoelectric/electrostrictive actuator 1 except that the number of laminates and the number of piezoelectric/electrostrictive films and electrode films to be formed increase.

### (5 Fifth Preferred Embodiment)

The fifth preferred embodiment relates to a piezoelectric/electrostrictive actuator 4 using the piezoelectric/electrostrictive ceramic composition according to the first preferred embodiment.

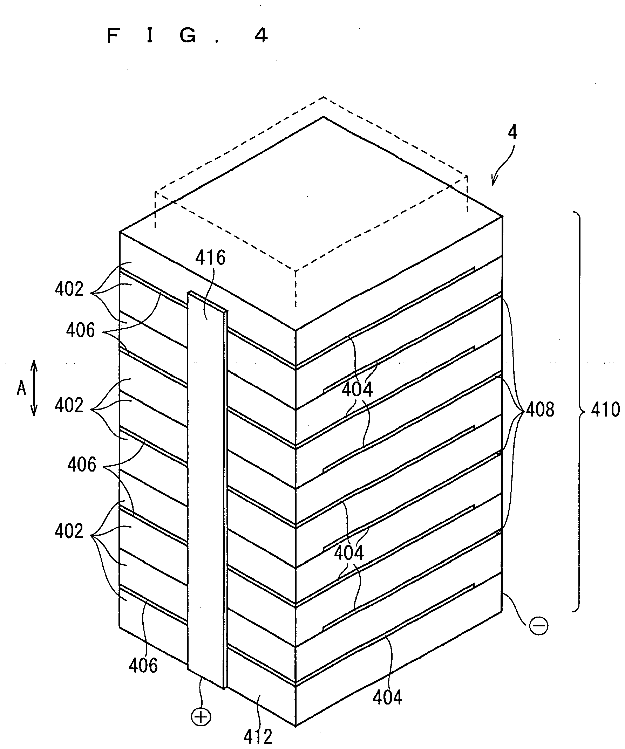

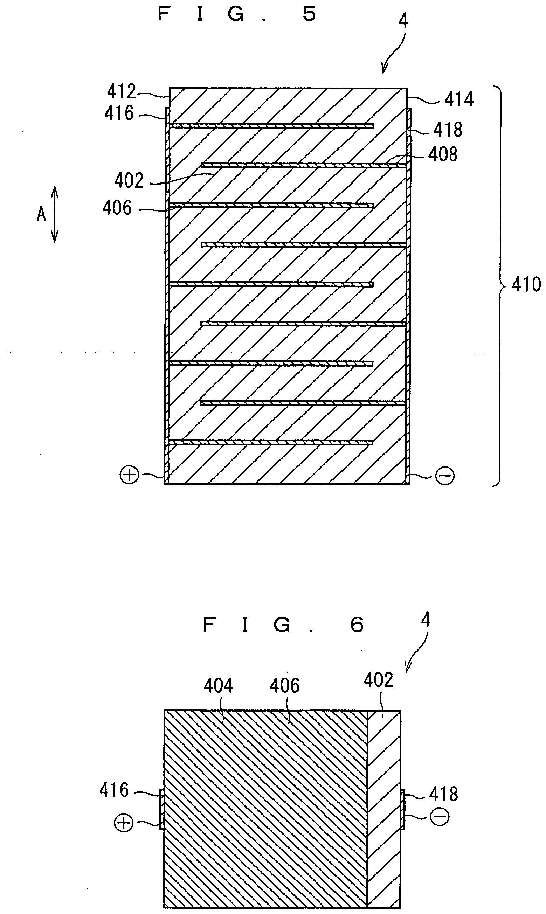

FIG. 4 to FIG. 6 are schematic views of the piezoelectric/electrostrictive actuator 4 according to the fifth preferred embodiment. FIG. 4 is a perspective view of the piezoelectric/electrostrictive actuator 4, FIG. 5 is a vertical cross-sectional view of the piezoelectric/electrostrictive actuator 4, and FIG. 6 is a lateral cross-sectional view of the piezoelectric/electrostrictive actuator 4.

As shown in FIG. 4 to FIG. 6, the piezoelectric/electrostrictive actuator 4 has a structure in which piezoelectric/electrostrictive films 402 and internal electrode films 404 are alternately laminated in an axis A direction, and external electrode films 416 and 418 are formed on end surfaces 412 and 414 of a laminate 410 in which the piezoelectric/electrostrictive films 402 and the internal electrode films 404 are laminated.

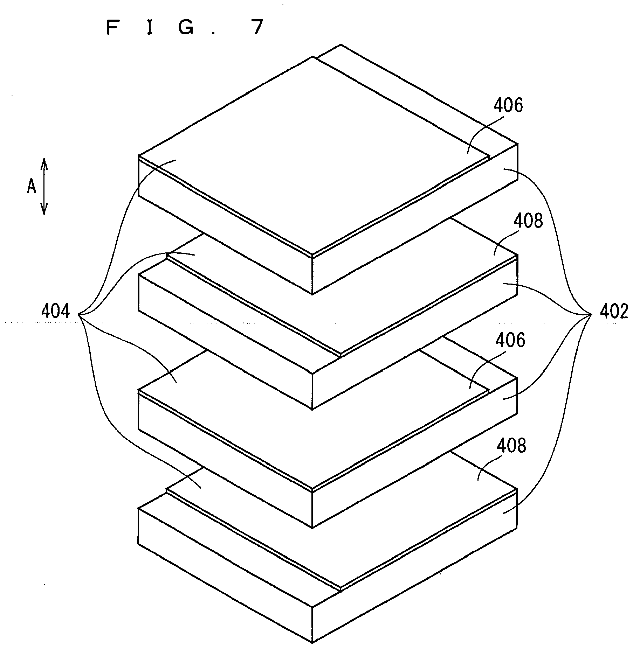

As shown in an exploded perspective view of FIG. 7 which shows a state in which a part of the piezoelectric/electrostrictive actuator 4 is disassembled in the axis A direction, the internal electrode films 404 are classified into first internal electrode films 406 which reach the end surface 412 but do not reach the end surface 414 and second internal electrode films 408 which reach the end surface 414 but do not reach the end surface 412. The first internal electrode films 406 and the second internal electrode films 408 are alternately provided. The first internal electrode films 406 are in contact with the external electrode film 416 on the end surface 412, and are electrically connected to the external electrode film 416. The second internal electrode films 408 are in contact with the external electrode film 418 on the end surface 414, and are electrically connected to the external electrode film 418. Accordingly, when the external electrode film 416 is connected to a plus side of a driving signal source and the external electrode film 418 is connected to a minus side of the driving signal source, a driving signal is applied to the first internal electrode film 406 and the second internal electrode film 408 which are opposed to each other with the piezoelectric/electrostrictive film 402 sandwiched therebetween, whereby an electric field is applied in the film thickness direction of the piezoelectric/electrostrictive film 402. As a result, the piezoelectric/electrostrictive films 402 expand and contract in the thickness direction, whereby the laminate 410 deforms into the shape indicated by a dotted line of FIG. 4 as a whole.

In contrast to the piezoelectric/electrostrictive actuators 1 to 3 described above, the piezoelectric/electrostrictive actuator 4 does not include a substrate to which the laminate 410 is fixed. In addition, the piezoelectric/electrostrictive actuator 4 is also referred to as an "offset type piezoelectric/electrostrictive actuator" because the first internal electrode films 406 and the second internal electrode films 408 having different patterns are alternately provided therein.

The piezoelectric/electrostrictive film 402 is a sintered body of the piezoelectric/electrostrictive ceramic composition according to the first preferred embodiment. A film thickness of the piezoelectric/electrostrictive film 402 is preferably 5 to 500 µm. This is because it is difficult to manufacture a green sheet described below if the film thickness falls below this range. In addition, it is difficult to apply a sufficient electric field to the piezoelectric/electrostrictive film 402 if the film thickness exceeds this range.

A material for the internal electrode film 404 and the external electrode films 416 and 418 is metal such as platinum, palladium, rhodium, gold or silver, or an alloy thereof. Among those, the material for the internal electrode film 404 is preferably platinum or an alloy mainly composed of platinum because heat resistance during firing is high and co-sintering with the piezoelectric/electrostrictive film 402 is performed easily. However, an alloy such as a silver-palladium alloy is preferably used depending on the firing temperature.

A film thickness of the internal electrode film 402 is desirably 10 µm or less. This is because the internal electrode film 402 functions as a buffer layer if the film thickness exceeds this range, whereby displacement tends to decrease. In order to cause the internal electrode film 402 to appropriately perform its function, the film thickness is desirably 0.1 µm or more.

Note that though FIG. 4 to FIG. 6 show the case of ten layers of the piezoelectric/electrostrictive films 402, nine or less, or eleven or more layers of the piezoelectric/electrostrictive films 402 may be provided.

In manufacturing the piezoelectric/electrostrictive actuator 4, a binder, a platicizer, a dispersing agent and a dispersing medium are added to ceramics powders of the piezoelectric/electrostrictive ceramic composition according to the first preferred embodiment, and those are mixed with a ball mill or the like. The obtained slurry is formed into a sheet shape by doctor blading or the like, whereby a green sheet is obtained.

Subsequently, the green sheet is subjected to punching process using a punch or die, whereby a hole or the like for alignment is formed in the green sheet.

Subsequently, an electrode paste is applied onto the surface of the green sheet by screen printing or the like, whereby the green sheet on which a pattern of the electrode paste is formed is obtained. The pattern of the electrode paste is classified into two types of a first pattern of the electrode paste which becomes the first internal electrode film 406 after firing and a second pattern of the electrode paste which becomes the second internal electrode film 408 after firing. Needless to say, only one type of pattern of electrode paste may be employed so that directions of the green sheets are rotated by 180 degrees every other sheet, to thereby obtain the internal electrode films 406 and 408 after firing.

Then, the green sheets on which the first pattern of the electrode paste is formed and the green sheets on which the second pattern of the electrode paste is formed are alternately laminated on each other, and the green sheet onto which the electrode paste is not applied is laminated on the uppermost part. After that, the laminated green sheets are pressurized and press-bonded in the thickness direction. On this occasion, positions of holes for alignment, which are formed in the green sheets, are caused to coincide with each other. Further, in press-bonding the laminated green sheets, the green sheets are desirably press-bonded while being heated by heating a die used for press-bonding in advance.

The press-bonded body of green sheets thus obtained is subjected to firing, and the obtained sintered body is processed with a dicing saw or the like, whereby the laminate 410 is obtained. Then, the external electrode films 416 and 418 are formed on the end surfaces 412 and 414 of the laminate 410, respectively, by firing, vapor deposition, sputtering and the like, and poling and aging are performed, whereby the piezoelectric/electrostrictive actuator 4 is obtained.

### (Example)

### (Production of piezoelectric/electrostrictive element for evaluation)

In manufacturing a piezoelectric/electrostrictive element for evaluation, powders of raw materials of lithium carbonate (Li₂CO₃), sodium bitartrate monohydrate (C₄H₅O₆Na·H₂O), potassium bitartrate (C₄H₅O₆K), niobium oxide (Nb₂O₅), tantalum oxide (Ta₂O₅) and antimony oxide (Sb₂O₃) were weighed so as to have compositions shown in Table 1 to Table 5 in an oxide after firing. Columns of "x", "y", "z", "w" and "a" of Table 1 to Table 5 show values of x, y, z, w and a when the composition of a perovskite-type oxide, which is the first component, is represented by the general formula {Li_{y}(Na₁₋ₓKₓ)_{1-y}}ₐ(Nb_{1-z-w}Ta_{z}Sb_{w})O₃. Note: samples A1, B1, B6, C1, C6 and D8 are comparative. Subsequently, alcohol was added as a dispersing medium to the weighed powders of raw materials and mixed for 16 hours with a ball mill.

Subsequently, the obtained mixed material was dried, and was subjected to calcination for 5 hours at 800°C and ground with a ball mill two times, whereby powders of a perovskite-type oxide were obtained.

After obtaining the powders of a perovskite-type oxide, powders of an oxide of a selected element or carbonate and MnO₂ were added so as to have contents shown in Table 1 to Table 5. Columns of "selected element" of Tables 1 to 5 show a type of a selected element, columns of "amount of selected element" thereof show a content of an oxide of a selected element or carbonate in terms of atom of the selected element with respect to 100 parts by mol of a perovskite-type oxide. Columns of "Mn amount" thereof show a content of MnO₂ in terms of Mn atom with respect to 100 parts by mol of a perovskite-type oxide.

Subsequently, the ceramics powders were sifted through a 500-mesh sieve after coarse grinding, to thereby adjust a particle size.

The ceramics powders thus obtained were subjected to pressing to be in a disk shape having a diameter of 18 mm and a plate thickness of 5 mm at a pressure of 2×10⁸ Pa. Then, except for sample numbers E1 and E2, the formed body was housed in an alumina container and then subjected to firing for 3 hours at 970°C, to hereby obtain a sintered body.

The sample number E1 was subjected to firing using a firing profile in which the following steps are successively executed:
(1) a first step of increasing a temperature to 1,000 to 1,050°C at a rate of temperature increase of 1,000°C/hour and holding for one minute;
(2) a second step of decreasing the temperature to 940 to 980°C at a rate of temperature decrease of 400 to 2,000°C/hour and holding for 3 to 6 hours; and
(3) a third step of cooling the temperature to a room temperature at a rate of temperature decrease of 200°C/hour.
A firing atmosphere of the sample number E1 is an oxygen atmosphere.

The sample number E2 was subjected to firing using a firing profile in which the following steps are successively performed:
(1) a first step of increasing a temperature to 860 to 900°C at a rate of temperature increase of 200°C/hour and holding for 0.5 to 3 hours;
(2) a second step of increasing the temperature to 1,000 to 1,050°C at a rate of temperature increase of 1,000°C/hour and holding for one minute;
(3) a third step of decreasing the temperature to 940 to 980°C at a rate of temperature decrease of 400 to 2,000°C/hour and holding for 3 to 6 hours; and
(4) a fourth step of cooling the temperature to a room temperature at a rate of temperature decrease of 200°C/hour.
A firing atmosphere of the sample number E2 is an oxygen atmosphere.

Subsequently, the sintered body was processed into a rectangular shape having a long side of 12 mm, a short side of 3 mm, and a thickness of 1 mm, and then was subjected to heat treatment at 600 to 900°C. After that, gold electrodes were formed on both principal surfaces of the rectangular sample by sputtering. Then, this was immersed in silicon oil of 70 to 100°C, and the gold electrodes on both principal surfaces were applied with a voltage of 5 kV/mm for 15 minutes for poling in a thickness direction, thereby performing aging.

### (Electrical characteristics)

A piezoelectric constant d₃₁ (pm/V) and a strain ratio S₄₀₀₀ (ppm) were measured using the piezoelectric/electrostrictive element for evaluation. The measurement results thereof are shown in Table 1 to Table 5. Tables 1, 2, 4 and 5 show the piezoelectric constant d₃₁ and the strain ratio S₄₀₀₀ after aging. Table 3 shows the piezoelectric constant d₃₁ and the strain ratio S₄₀₀₀ after poling and after/before aging.

The piezoelectric constant d₃₁ was obtained by measuring a frequency-impedance characteristic of the piezoelectric/electrostrictive element and an electrostatic capacitance with an impedance analyzer and measuring a size of the piezoelectric/electrostrictive element with a micrometer, and then calculating from a resonance frequency and an anti-resonance frequency of a fundamental wave of a vibration extending in the long side direction, the electrostatic capacitance and the size. The strain ratio S₄₀₀₀ was obtained by measuring electric field induced strain in the long side direction when the gold electrodes on both principal surfaces were applied with a voltage of 4 kV/mm with a strain gauge attached to the electrode with an adhesive.

The comparison of sample numbers A1 to A8 of Table 1 reveals that the piezoelectric constant d₃₁ and the strain ratio S₄₀₀₀ are improved by containing compounds of Ba, Sr, Ca, La, Ce, Nd and Sm. In addition, microstructures and crystal phases of the sintered bodies of the sample numbers A1 to A8 were approximately the same, a particle diameter thereof was approximately 10 µm, and a relative density thereof was 94 to 96%.

**(Table 1)**

| Sample No. | Selected element | Amount of selected element (part by mol) | Amount of Mn (part by mol) | d₃₁ (pm/V) | S₄₀₀₀ (ppm) | x | y | z | w | a |
|---|---|---|---|---|---|---|---|---|---|---|
| A1 | n/a | 0.05 | 0.02 | 91 | 750 | 0.45 | 0.06 | 0.082 | 0.04 | 1.01 |
| A2 | Ba | 0.05 | 0.02 | 117 | 810 | 0.45 | 0.06 | 0.082 | 0.04 | 1.01 |
| A3 | Sr | 0.05 | 0.02 | 117 | 830 | 0.45 | 0.06 | 0.082 | 0.04 | 1.01 |
| A4 | Ca | 0.05 | 0.02 | 119 | 790 | 0.45 | 0.06 | 0.082 | 0.04 | 1.01 |
| A5 | La | 0.05 | 0.02 | 118 | 790 | 0.45 | 0.06 | 0.082 | 0.04 | 1.01 |
| A6 | Ce | 0.05 | 0.02 | 118 | 780 | 0.45 | 0.06 | 0.082 | 0.04 | 1.01 |
| A7 | Nd | 0.05 | 0.02 | 100 | 770 | 0.45 | 0.06 | 0.082 | 0.04 | 1.01 |
| A8 | Sm | 0.05 | 0.02 | 95 | 760 | 0.45 | 0.06 | 0.082 | 0.04 | 1.01 |

The comparison of sample numbers B1 to B6 of Table 2 reveals that in a case where the selected element is Ba, the piezoelectric constant d₃₁ and the strain ratio S₄₀₀₀ are improved within a range where an amount of Ba is 0.01 to 0.50 parts by mol but excellent piezoelectric constant d₃₁ and strain ratio S₄₀₀₀ are not obtained when the amount of Ba is 0.60 parts by mol. Similarly, referring to sample numbers C1 to C6 of Table 3, it is revealed that in a case where the selected element is Sr, the piezoelectric constant d₃₁ and the strain ratio S₄₀₀₀ are improved within a range where an amount of Sr is 0.01 to 0.50 parts by mol but excellent piezoelectric constant d₃₁ and strain ratio S₄₀₀₀ are not obtained when the amount of Sr is 0.60 parts by mol. Moreover, a main crystal phase of a sintered body was tetragonal within the range where the amount of Ba and the amount of Sr were 0.01 to 0.50 parts by mol, and the main crystal phase of the sintered body changed into orthorhombic when the amount of Ba and the amount of Sr were 0.60 parts by mol.

**(Table 2)**

| Sample No. | Selected element | Amount of selected element (part by mol) | Amount of Mn (part by mol) | d₃₁ (pm/V) | S₄₀₀₀ (ppm) | x | y | z | w | a |
|---|---|---|---|---|---|---|---|---|---|---|
| B1 | Ba | 0.00 | 0.02 | 92 | 735 | 0.36 | 0.06 | 0.082 | 0.04 | 1.01 |
| B2 | Ba | 0.01 | 0.02 | 97 | 865 | 0.36 | 0.06 | 0.082 | 0.04 | 1.01 |
| B3 | Ba | 0.10 | 0.02 | 98 | 870 | 0.36 | 0.06 | 0.082 | 0.04 | 1.01 |
| B4 | Ba | 0.20 | 0.02 | 98 | 885 | 0.36 | 0.06 | 0.082 | 0.04 | 1.01 |
| B5 | Ba | 0.50 | 0.02 | 94 | 850 | 0.36 | 0.06 | 0.082 | 0.04 | 1.01 |
| B6 | Ba | 0.60 | 0.02 | 64 | 550 | 0.36 | 0.06 | 0.082 | 0.04 | 1.01 |

**(Table 3)**

| Sample No. | Selected element | Amount of selected element (part by mol) | Amount of Mn (part by mol) | d₃₁ (pm/V) | S₄₀₀₀ (ppm) | x | y | z | w | a |
|---|---|---|---|---|---|---|---|---|---|---|
| C1 | Sr | 0.00 | 0.02 | 92 | 735 | 0.36 | 0.06 | 0.082 | 0.04 | 1.01 |
| C2 | Sr | 0.01 | 0.02 | 93 | 880 | 0.36 | 0.06 | 0.082 | 0.04 | 1.01 |
| C3 | Sr | 0.10 | 0.02 | 96 | 890 | 0.36 | 0.06 | 0.082 | 0.04 | 1.01 |
| C4 | Sr | 0.20 | 0.02 | 94 | 880 | 0.3 6 | 0.06 | 0.082 | 0.04 | 1.01 |
| C5 | Sr | 0.50 | 0.02 | 93 | 860 | 0.36 | 0.06 | 0.082 | 0.04 | 1.01 |
| C6 | Sr | 0.60 | 0.02 | 54 | 635 | 0.36 | 0.06 | 0.082 | 0.04 | 1.01 |

Referring to sample numbers D1 to D8 of Table 4, the piezoelectric constant d₃₁ and the strain ratio S₄₀₀₀ are improved by aging within a range where the A/B ratio is 1.005 to 1.05, but the piezoelectric constant d₃₁ and the strain ratio S₄₀₀₀ are not improved by aging when the A/B ratio is 1 or 1.055. In addition, in a case where the A/B ratio is 1, the sintered body was insufficiently densified and grain growth was insufficient as well. On the other hand, in a case where the A/B ratio is 1.055, the secondary phase was observed in the sintered body and dielectric loss increased.

**(Table 4)**

| Sample No. | Selected element | Amount of selected element (part by mol) | Amount of Mn (part by mol) | d₃₁ (pm/V) after poling | S₄₀₀₀ (ppm) after poling | d₃₁ (pm/V) after aging | S₄₀₀₀ (ppm) after aging | x | y | z | w | a |
|---|---|---|---|---|---|---|---|---|---|---|---|---|
| D1 | Sr | 0.1 | 1.00 | 73 | 640 | 64 | 550 | 0.36 | 0.06 | 0.082 | 0.04 | 1.000 |
| D2 | Sr | 0.1 | 0.40 | 87 | 670 | 92 | 780 | 0.36 | 0.06 | 0.082 | 0.04 | 1.005 |
| D3 | Sr | 0.1 | 0.05 | 84 | 690 | 96 | 900 | 0.36 | 0.06 | 0.082 | 0.04 | 1.011 |
| D4 | Sr | 0.1 | 0.10 | 87 | 670 | 98 | 930 | 0.36 | 0.06 | 0.082 | 0.04 | 1.011 |
| D5 | Sr | 0.1 | 0.20 | 86 | 650 | 96 | 890 | 0.36 | 0.06 | 0.082 | 0.04 | 1.012 |
| D6 | Sr | 0.1 | 0.50 | 83 | 610 | 93 | 760 | 0.3 6 | 0.06 | 0.082 | 0.04 | 1.015 |
| D7 | Sr | 0.1 | 3.00 | 80 | 590 | 92 | 740 | 0.36 | 0.06 | 0.082 | 0.04 | 1.050 |
| D8 | Sr | 0.1 | 4.00 | 62 | 550 | 45 | 420 | 0.36 | 0.06 | 0.082 | 0.04 | 1.055 |

Excellent piezoelectric constant d₃₁ and strain ratio S₄₀₀₀ were obtained in the sample numbers E1 and E2 of Table 5 whose firing profile was changed. Note that even in a case where the composition of the piezoelectric/electrostrictive ceramic composition was changed within the scope of the present invention, excellent piezoelectric constant d₃₁ and strain ratio S₄₀₀₀ were obtained when the firing profile employed in the sample numbers E1 and E2 was adopted.

**(Table 5)**

| Sample No. | Selected element | Amount of selected element (part by mol) | Amount of Mn (part by part) | d₃₁ (pm/V) | S₄₀₀₀ (ppm) | x | y | z | w | a |
|---|---|---|---|---|---|---|---|---|---|---|
| E1 | Sr | 0.05 | 0.02 | 121 | 880 | 0.45 | 0.06 | 0.082 | 0.04 | 1.01 |
| E2 | Sr | 0.05 | 0.02 | 126 | 930 | 0.45 | 0.06 | 0.082 | 0.04 | 1.01 |

While the invention has been shown and described in detail, the foregoing description is in all aspects illustrative and not restrictive. It is therefore understood that numerous modifications and variations can be devised without departing from the scope of the invention as defined in the appended claim.

## Claims

1. A sintered body of a piezoelectric/electrostrictive ceramic composition, in which a compound of at least one kind of element selected from the group consisting of Ba, Sr, Ca, La, Ce, Nd, Sm, Dy, Ho and Yb and a Mn compound are contained in a perovskite-type oxide having a composition represented by a general formula {Li_{y}(Na₁₋ₓKₓ)_{1-y}}ₐ(Nb_{1-z-w}Ta_{z}Sb_{w})O₃, where a, x, y, z and w satisfy 1<a≤1.05, 0.30≤x≤0.70, 0.02≤y≤0.10, 0≤z≤0.5 and 0.01≤w≤0.1, respectively,
wherein a content of said compound of the selected element in terms of atoms of the selected element with respect to 100 parts by mol of said perovskite-type oxide is 0.01 parts by mol or more and 0.5 parts by mol or less, and
wherein a content of said Mn compound in terms of Mn atom with respect to 100 parts by mol of said perovskite-type oxide is 3 parts by mol or less, and
wherein, considering the perovskite-type oxide as a parent phase, Mn is present inside the sintered body of the piezoelectric/electrostrictive ceramic composition as an element constituting a Mn compound secondary phase, without the Mn being taken in a crystal lattice of the parent phase.

## Patentansprüche

1. Gesinterter Körper aus einer piezoelektrischen/elektrostriktiven keramischen Zusammensetzung, in der eine Verbindung von mindestens einem Element-Typ, der aus der aus Ba, Sr, Ca, La, Ce, Nd, Sm, Dy, Ho und Yb bestehenden Gruppe ausgewählt ist, und eine Mn-Verbindung in einem Perowskit-Typ-Oxid enthalten sind, das eine Zusammensetzung aufweist, die durch eine allgemeine Formel {Li_{y}(Na₁₋ₓKₓ)_{1-y}}ₐ(Nb_{1-z-w}Ta_{z}Sb_{w})O₃ repräsentiert wird, worin a, x, y, z und w 1<a≤1,05, 0,30≤x≤0,70, 0,02≤y≤0,10, 0≤z≤0,5 beziehungsweise 0,01≤w≤0,1 erfüllen,
worin ein Gehalt der Verbindung des ausgewählten Elements in Form von Atomen des ausgewählten Elements mit Bezug auf 100 Anteile pro Mol des Perowskit-Typ-Oxids 0,01 Anteile pro Mol oder mehr und 0,5 Anteile pro Mol oder weniger ist, und
worin ein Gehalt der Mn-Verbindung in Form eines Mn-Atoms mit Bezug auf 100 Anteile pro Mol des Perowskit-Typ-Oxids 3 Anteile pro Mol oder weniger ist, und
worin, bei Berücksichtigung des Perowskit-Typ-Oxids als eine Ausgangsphase, Mn im Inneren des gesinterten Körpers der piezoelektrischen/elektrostriktiven keramischen Zusammensetzung als ein Element vorhanden ist, das eine sekundäre Mn-Verbindungsphase darstellt, ohne dass das Mn in einem Kristallgitter der Ausgangsphase aufgenommen ist.

## Revendications

1. Corps fritté d'une composition céramique piézoélectrique/électrostrictive, dans lequel un composé d'au moins un type d'élément choisi dans le groupe constitué par Ba, Sr, Ca, La, Ce, Nd, Sm, Dy, Ho et Yb et un composé de Mn sont contenus dans un oxyde de type perovskite ayant une composition représentée par la formule générale
{Li_{y}(Na₁₋ₓKₓ)_{1-y}}ₐ(Nb_{1-z-w}Ta_{z}Sb_{w})O₃ dans laquelle a, x, y, z et w satisfont à 1 < a ≤ 1,05, 0,30 ≤ x ≤ 0,70, 0,02 ≤ y ≤ 0,10, 0 ≤ z ≤ 0,5 et 0,01 ≤ w ≤ 0,1, respectivement,
dans lequel la teneur en ledit composé de l'élément sélectionné, en termes d'atome de l'élément sélectionné pour 100 parties en moles dudit oxyde de type perovskite, est de 0,01 partie en moles ou plus et de 0,5 partie en moles ou moins, et
dans lequel la teneur en ledit composé de Mn, en termes d'atomes de Mn pour 100 parties en moles dudit oxyde de type perovskite, est de 3 parties en moles ou moins, et
dans lequel, l'oxyde de type perovskite étant considéré être une phase mère, Mn est présent à l'intérieur du corps fritté de la composition céramique piézoélectrique/électrostrictive en tant qu'élément constituant une phase secondaire de composé de Mn, sans que le Mn soit pris dans un réseau cristallin de la phase mère.
